(19) Europäisches Patentamt
European Patent Office
Office européen des brevets

(11) **EP 4 459 299 A1**

(12) **DEMANDE DE BREVET EUROPEEN**

(43) Date de publication:
**06.11.2024 Bulletin 2024/45**

(21) Numéro de dépôt: **24172895.5**

(22) Date de dépôt: **29.04.2024**

(51) Classification Internationale des Brevets (IPC):
*G01R 31/379* (2019.01)    *G01R 31/392* (2019.01)

(52) Classification Coopérative des Brevets (CPC):
**G01R 31/379; G01R 31/392;** G01R 31/374

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **03.05.2023 FR 2304455**

(71) Demandeur: **Ampere SAS**
**92100 Boulogne-Billancourt (FR)**

(72) Inventeur: **Saint-Leger, Gerard**
**78280 Guyancourt (FR)**

(74) Mandataire: **Renault Group**
**Renault s.a.s.**
**1 avenue du Golf**
**FR TCR AVA 055**
**78084 Guyancourt Cedex (FR)**

(54) **PROCEDE ET SYSTEME DE DETERMINATION D'UN INDICATEUR D'USURE D'UNE BATTERIE AU PLOMB POUR VEHICULE AUTOMOBILE**

(57)   Procédé de détermination d'un indicateur d'usure d'une batterie (2) au plomb pour véhicule automobile (1), caractérisé en ce que l'on calcule en continu un indicateur d'usure de la batterie (2) selon un mode d'usage du véhicule (1) et en fonction de paramètres de fonctionnement de la batterie (2), ledit procédé comprenant les étapes suivantes :
- Lorsque le véhicule (1) est actif, calcul d'un premier indicateur d'usure ($U_a$) de la batterie (2) à l'aide de paramètres de fonctionnement comprenant un temps d'analyse ($A$) et la température interne ($T$) de la batterie (2),
- Lorsque le véhicule (1) est inactif, calcul d'un second indicateur d'usure ($U_p$) de la batterie (2) à l'aide de paramètres de fonctionnement comprenant un temps d'analyse ($A$), la température interne ($T$) de la batterie (2), ainsi que l'état de charge *(SOC)* de la batterie (2).

[Fig 4]

EP 4 459 299 A1

**Description**

*Domaine technique*

La présente invention concerne le domaine des batteries au plomb et concerne plus particulièrement la mesure de l'usure d'une batterie au plomb.

Il s'agit en particulier de déterminer l'usure d'une batterie au plomb d'un véhicule automobile destinée à l'alimentation des divers équipements de bord d'un véhicule.

Dans un véhicule automobile, la durée de vie d'une batterie est très inférieure à celle du véhicule. Elle est par exemple au maximum de 8 ans dans des conditions optimales d'utilisation, notamment pour une température interne constante de 15°C. Elle doit être remplacée avant d'être totalement usée, au risque de provoquer une panne immobilisant le véhicule. En effet, la batterie est l'élément qui fournit l'énergie et l'intensité électrique nécessaires pour démarrer le véhicule. Si la batterie ne fonctionne plus, le circuit électrique du véhicule n'est pas alimenté empêchant son démarrage.

La durée de vie d'une batterie dépend de plusieurs paramètres, tels que le mode d'usage du véhicule, la région d'utilisation du véhicule, la température interne de la batterie, l'état de charge de la batterie... Selon ces paramètres, la durée de vie de la batterie varie du simple au triple.

Il est donc nécessaire de connaître la durée de vie restante de la batterie afin de déterminer quand elle est sur le point de ne plus fonctionner et quand elle doit être remplacée.

*Techniques antérieures*

On connaît, du document US-B-6,836,122, un système de calcul de la durée de vie d'une batterie destiné à calculer un indicateur d'usure en prenant en compte la température de la batterie, la valeur du courant de charge/décharge de la batterie et l'état de charge de la batterie, en appliquant des coefficients d'usure pour chacun de ces paramètres de fonctionnement de la batterie.

Ce système, en revanche, ne prend pas en compte dans ses calculs tous les cas et conditions d'usage, notamment ceux d'une batterie au plomb, de sorte que l'indicateur d'usure calculé serait peu précis selon cette méthode. En effet, les conditions d'usage de la batterie ont une influence majeure sur sa durée de vie. C'est notamment le cas lorsque le véhicule est en mode parking, c'est-à-dire lorsque la batterie ne délivre pas de courant pendant une durée qui peut être relativement longue, et que l'état de charge est fortement réduit, ce qui engendre une usure rapide de la batterie. Il est donc important de prendre en compte ce cas et conditions d'usage d'un véhicule dans le calcul d'un indicateur d'usure d'une batterie au plomb.

*Exposé de l'invention*

La présente invention a donc pour but de mesurer l'état d'usure d'une batterie en généralisant la surveillance des paramètres d'usure aux conditions de fonctionnement qui ont un impact prépondérant sur la durée de vie restante de la batterie.

L'invention a donc pour objet un procédé de détermination d'un indicateur d'usure d'une batterie au plomb pour véhicule automobile.

Ce procédé comprend le calcul en continu d'un indicateur d'usure de la batterie en fonction de paramètres de fonctionnement de la batterie et selon un mode d'usage du véhicule, et comprend les étapes suivantes :

- Lorsque le véhicule est actif, c'est-à-dire lorsque la batterie fournit un courant d'alimentation au véhicule, le calcul d'un premier indicateur d'usure $U_a$ de la batterie à l'aide de paramètres de fonctionnement comprenant un temps d'analyse $A$ et la température interne $T$ de la batterie.
- Lorsque le véhicule est inactif, c'est-à-dire lorsque la batterie ne fournit qu'un courant de veille au véhicule, le calcul d'un second indicateur d'usure $U_p$ de la batterie à l'aide de paramètres de fonctionnement comprenant un temps d'analyse $A$, la température interne $T$ de la batterie, ainsi que l'état de charge $SOC$ de la batterie.

Une fois le calcul effectué, on obtient un indicateur d'usure mesuré en temps d'utilisation, ayant une unité temporelle (par exemple en heures ou en jours), qui peut être additionnée à un indicateur d'usure total, également mesuré en temps d'utilisation de la batterie, qui est stocké dans le véhicule automobile. Le résultat de cette addition devient le nouvel indicateur d'usure total de la batterie, qui sera additionné au prochain indicateur d'usure calculé.

Avantageusement, le premier indicateur d'usure $U_a$ de la batterie au plomb lorsque le véhicule est actif, est calculé selon la relation :

$$U_a = A * K_T$$

dans laquelle $K_T$ est un facteur d'usure déterminé selon la loi Arrhenius, représentant une usure proportionnelle au temps d'analyse $A$ et en fonction de la température interne $T$ de la batterie.

Avantageusement, le deuxième indicateur d'usure $U_p$ de la batterie au plomb lorsque le véhicule est inactif, est calculé selon la relation :

$$U_p = U_T + U_{SOC} - U_i$$

- dans laquelle :

  - $U_T$ est un indicateur d'usure de la batterie en fonction de la température $T$ et correspond à :
  $U_T = A * K_T$ ; si le temps d'analyse $A$ est inférieur ou égal à 24 heures, ou :
  $U_T = (24 * K_T) + ((A - 24) * K_{Ta})$ ; si $A$ est supérieur à 24 heures,
  Avec $K_T$ le facteur d'usure déterminé selon la loi Arrhenius et :

$$T = \frac{(T_s + T_a)}{2}$$

  dans laquelle $T_s$ est la température interne de la batterie juste avant que le véhicule ne devienne inactif, et $T_a$ la température interne de la batterie lorsque le contact est mis, c'est-à-dire lorsque le véhicule devient actif,
  - $U_{SOC}$ est un indicateur d'usure de la batterie en fonction de l'état de charge $SOC$ de la batterie, et
  - $U_i$ est l'indicateur d'usure initial de la batterie.

Avantageusement, l'indicateur d'usure $U_{SOC}$ de la batterie lorsque le véhicule est inactif est déterminé selon la relation :

$$U_{SOC} = \frac{(SOC_a - SOC_b)}{l} * K_{SOC_b}$$

- dans laquelle :

  - $SOC_a$ est l'état de charge de la batterie au début d'une période d'analyse,
  - $SOC_b$ est l'état de charge de la batterie à la fin d'une période d'analyse, l'état de charge étant pondéré par un coefficient d'usure $K_{SOCb}$ correspondant à l'état de charge $SOC_b$, et
  - $l$ étant la perte de charge pour un jour.

Avantageusement, l'indicateur d'usure $U_i$ correspond à l'usure d'une batterie ayant une température interne $T$ de 15°C et un état de charge $SOC$ de 90%, lorsque le véhicule est inactif.

Selon un mode de réalisation de l'invention, l'indicateur d'usure de la batterie au plomb correspondant au mode d'usage du véhicule est calculé périodiquement lorsque le véhicule est actif. L'indicateur d'usure de la batterie au plomb lorsque le véhicule est inactif est calculé au moment où le véhicule devient actif.

L'invention a également pour objet un système de détermination d'un indicateur d'usure d'une batterie au plomb pour véhicule automobile, comprenant un calculateur électronique configuré pour calculer en continu un indicateur d'usure de la batterie, selon un mode d'usage du véhicule et en fonction de paramètres de fonctionnement de la batterie. Ce calcul d'un indicateur d'usure de la batterie comprend les étapes suivantes :

- Lorsque le véhicule est actif, c'est-à-dire lorsque la batterie fournit un courant d'alimentation au véhicule, le calcul d'un premier indicateur d'usure $U_a$ de la batterie à l'aide de paramètres de fonctionnement comprenant un temps d'analyse $A$ et la température interne $T$ de la batterie.
- Lorsque le véhicule est inactif, c'est-à-dire lorsque la batterie ne fournit qu'un courant de veille au véhicule, le calcul d'un second indicateur d'usure $U_p$ de la batterie à l'aide de paramètres de fonctionnement comprenant un temps d'analyse $A$, la température interne $T$ de la batterie, ainsi que l'état de charge $SOC$ de la batterie.

Une fois le calcul effectué, on obtient un indicateur d'usure mesuré en temps d'utilisation, ayant une unité temporelle (par exemple en heures ou en jours), qui peut être additionnée à un indicateur d'usure total, également mesuré en temps d'utilisation de la batterie, qui est stocké dans le véhicule automobile. Le résultat de cette addition devient le nouvel indicateur d'usure total de la batterie, qui sera additionné au prochain indicateur d'usure calculé.

L'invention a encore pour objet un véhicule automobile comprenant un système de détermination d'un indicateur d'usure tel que défini ci-dessus.

### Brève description des dessins

D'autres buts, caractéristiques et avantages de l'invention apparaîtront à la lecture de la description suivante, donnée uniquement à titre d'exemple non limitatif et faite en référence aux dessins annexés sur lesquels :

- La [Fig. 1] est une vue schématique d'un véhicule automobile équipé d'un système de détermination d'un indicateur d'usure d'une batterie conforme à l'invention ;
- La [Fig. 2] représente schématiquement les principales étapes d'un procédé de détermination d'un indicateur d'usure d'une batterie conforme à l'invention ;
- La [Fig. 3] représente graphiquement l'évolution de l'état de charge de la batterie en fonction du temps ; et
- La [Fig. 4] représente graphiquement l'évolution de l'usure de la batterie en fonction de ses conditions de fonctionnement.

### Description détaillée

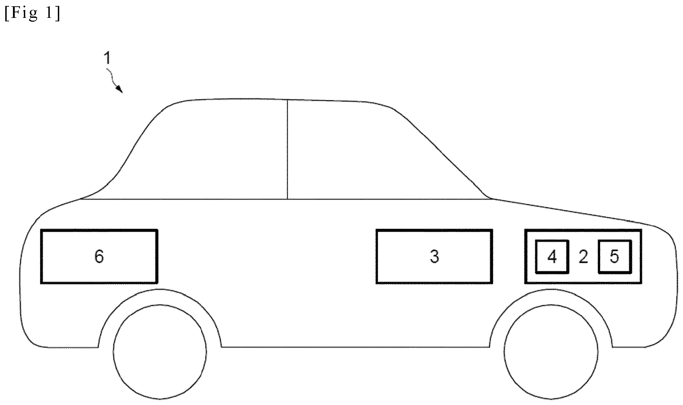

Sur la figure 1 on a représenté schématiquement la structure d'un véhicule automobile 1, selon un mode de réalisation de l'invention, comprenant une batterie au plomb 2 et un système de détermination de l'usure de la batterie destiné à calculer un indicateur d'usure de la batterie 2.

La batterie 2 est destinée à l'alimentation électrique de divers équipements ou charges électriques embarquées à bord du véhicule. Lorsque le moteur est à l'arrêt, elle permet d'alimenter les équipements qui doivent rester sous tension, tels que le calculateur de bord du véhicule. Lorsque le moteur tourne, elle est rechargée par l'alternateur.

En plus de l'usure calendaire d'une batterie au plomb, plusieurs paramètres influent sur la durée de vie de la batterie, comme la température interne de la batterie et l'état de charge de la batterie. En effet, indépendamment des cycles de charge et de décharge d'une batterie, le principal paramètre d'usure d'une batterie au plomb est la corrosion. Les réactions chimiques entre l'acide sulfurique et le plomb dégradent la batterie, même sans décharge ou cycle de charge et de décharge. Cette usure est directement proportionnelle au temps et est accélérée par la température interne de la batterie.

Le système de détermination d'un indicateur d'usure de la batterie comporte ainsi un calculateur électronique 3, un capteur de température 4 apte à mesurer la température interne de la batterie 2, un capteur de charge 5 apte à déterminer l'état de charge de la batterie 2 et un compteur de temps absolu 6 destiné à déterminer l'âge de la batterie à compter de sa sortie d'usine.

Le calculateur électronique 3 calcule l'indicateur d'usure à partir de la température interne de la batterie 2, de l'état de charge de la batterie 2 et de la durée $A$ de la période pendant laquelle est calculé l'indicateur d'usure, selon la procédure suivante.

Selon l'état du véhicule 1, à savoir actif ou inactif, différents paramètres sont pris en compte pour calculer l'indicateur d'usure de la batterie 2. Lorsque le véhicule 1 est actif, la batterie 2 alimente le réseau de bord du véhicule et fournit un courant d'alimentation tendant à décharger la batterie, tandis que lorsque le véhicule 1 est inactif, la batterie 2 n'assure l'alimentation que de certains équipements, tels que le calculateur électronique 3.

Un premier indicateur d'usure $U_a$ est calculé lorsque le véhicule 1 est actif. Les principaux paramètres pris en compte pour le calcul de ce premier indicateur d'usure $U_a$ sont la durée $A$ de la période pendant laquelle est calculé l'indicateur d'usure $U_a$ et la température interne $T$ de la batterie 2. Selon la loi d'Arrhenius, l'usure de la batterie 2 est proportionnelle au temps et est accélérée par la température interne de la batterie 2.

L'indicateur d'usure $U_a$ calculé par le système de détermination de l'indicateur d'usure de la batterie, est déterminé à partir du tableau I suivant :

[Table 1]

| TEMP interne (°C) | Facteur d'usure $K_T$ |
|---|---|
| T<=15 | 1 |
| 20 | 1,4 |

(suite)

| TEMP interne (°C) | Facteur d'usure $K_T$ |
|---|---|
| 25 | 2,0 |
| 30 | 2,8 |
| 35 | 4 |
| 40 | 5,6 |
| 45 | 8 |

Le tableau I représente l'évolution du facteur d'usure selon la température interne de la batterie 2. Une batterie 2 dont la température interne serait de 45°C, s'userait par exemple en 1 heure de la même manière qu'une même batterie 2 avec une température interne par exemple de 15°C s'userait en 8 heures.

Un second indicateur d'usure $U_p$ est calculé lorsque le véhicule 1 est inactif. Les paramètres pris en compte pour le calcul de ce second indicateur d'usure $U_p$ sont la durée $A$ de la période sur laquelle est calculé l'indicateur d'usure, à savoir la durée $A$ durant laquelle le véhicule 1 est resté inactif, la température interne $T$ de la batterie 2, et l'état de charge SOC (« State Of Charge », en anglais) de la batterie 2. L'indicateur d'usure $U_p$ est alors calculé à partir du tableau II suivant :

[Table 2]

| SOC (State Of Charge) | $K_{SOC}$ (pondération des heures de parking) |
|---|---|
| >90% | 1 |
| 80% > SOC > 90% | 1,1 |
| 70% > SOC > 80% | 3 |
| SOC< 70% | 8 |

Le tableau II représente l'évolution du facteur d'usure selon l'état de charge de la batterie 2.

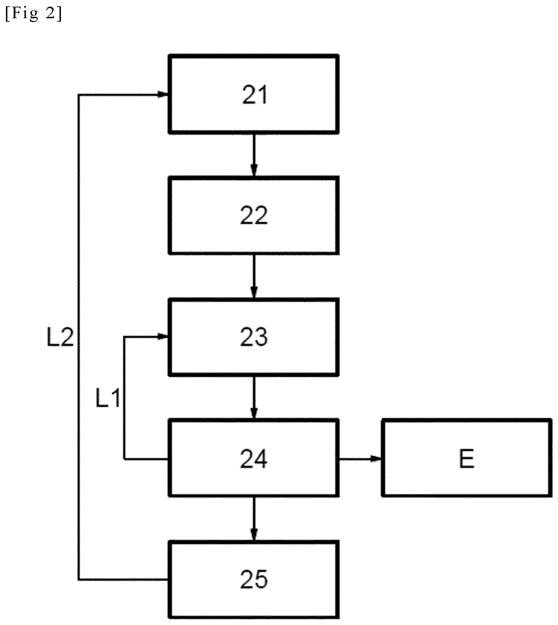

La figure 2 détaille l'enchaînement des étapes du procédé selon l'invention. Le mode de mise en oeuvre décrit s'applique à un véhicule automobile 1 préalablement inactif avant l'exécution du procédé.

Lors de la première étape 21, le véhicule 1 devient actif après une période d'inactivité. Le rôle du calculateur électronique 3 est, tout d'abord, de calculer l'indicateur d'usure mesuré en temps d'utilisation de la batterie 2 durant la période d'inactivité du véhicule 1. L'unité temporelle du temps d'utilisation est par exemple exprimée en heures ou en jours. Le calculateur récupère alors les paramètres destinés au calcul de l'indicateur d'usure.

Le calculateur 3 récupère en premier lieu la durée $A$ pendant laquelle le véhicule 1 est resté inactif. Le calculateur électronique 3 récupère l'âge du véhicule 1 à sa mise en veille, c'est-à-dire juste avant que le véhicule 1 devienne inactif, et l'âge du véhicule 1 une fois activé, grâce au compteur de temps absolu 6.

Le calculateur récupère en outre les températures internes $T_s$ et $T_a$ de la batterie 2, $T_s$ étant la température interne de la batterie 2 juste avant la mise en veille du véhicule 1 et $T_a$ étant la température interne de la batterie 2 à l'activation du véhicule 1. Elles sont déterminées grâce au capteur de température interne 4 de la batterie 2.

Le calculateur récupère enfin les états de charge SOC de la batterie 2, avant la mise en veille du véhicule 1 et à l'activation du véhicule 1, grâce au capteur de l'état de charge 5 de la batterie 2.

Avec ces trois paramètres $T_s$, $T_a$, et SOC, le calculateur électronique 3 calcule l'indicateur d'usure $U_p$ exprimé en temps passé de la batterie 2 pendant la durée $A$ pendant laquelle le véhicule 1 était inactif, selon la relation suivante :

$$U_p = U_T + U_{SOC} - U_i$$

Dans laquelle :

- L'indicateur d'usure $U_T$ correspond à l'usure de la batterie 2 en fonction de la température $T$ selon les relations :

  $U_T = A * K_T$ ; si la durée $A$ est inférieure ou égale à 24 heures, et

$U_T = (24 * K_T) + ((A - 24) * K_{Ta})$ ; si la durée $A$ est supérieure à 24 heures, avec $T = \frac{(T_s + T_a)}{2}$ et $K_T$ le facteur d'usure selon la température $T$ déterminé d'après la loi Arrhenius, définie par le tableau I.

- L'indicateur d'usure $U_{SOC}$ correspond à l'usure de la batterie 2 en fonction de l'état de charge, déterminée selon la relation :

$$U_{SOC} = \frac{(SOC_a - SOC_b)}{l} * K_{SOC_b} \; ;$$

Dans laquelle $SOC_a$ et $SOC_b$ désignent respectivement l'état de charge de la batterie 2 au début d'une période d'analyse, et l'état de charge de la batterie 2 à la fin d'une période d'analyse, et $l$ représente la perte de charge de la batterie 2 pour un jour.

Pour effectuer ces calculs, le calculateur électronique 3 récupère le facteur d'usure $K_{SOCb}$, en fonction de l'état de charge $SOC$ déterminé d'après le tableau II.

Pendant la durée $A$ d'inactivation du véhicule, l'état de charge $SOC$ évolue. Cette variation se traduit par la différence entre l'état de charge en début d'analyse $SOC_a$ et l'état de charge en fin d'analyse $SOC_b$.

S'il n'y a pas de variation de l'état de charge $SOC$ de la batterie 2 pendant la durée $A$ d'inactivité du véhicule 1, l'état de charge $SOC_b$ est nul et la perte de charge $l$ est égale à 1.

En revanche, si l'état de charge $SOC$ total de la batterie 2 a diminué pendant la durée $A$ d'inactivité du véhicule 1, le calcul est découpé en quatre périodes d'analyse, selon les intervalles de 10% des états de charge $SOC$ du tableau II. La première période d'analyse correspond à un état de charge de la batterie 2 $SOC$ supérieur à 90%. La deuxième période d'analyse correspond à un état de charge $SOC$ de la batterie compris entre 80% et 90%. La troisième période d'analyse correspond à un état de charge $SOC$ de la batterie compris entre 70% et 80% et la quatrième période d'analyse correspond à un état de charge de la batterie 2 $SOC$ inférieur à 70%.

Les différents résultats de ces périodes d'analyse seront ensuite additionnés pour fournir l'indicateur d'usure $U_{SOC}$ total.

L'indicateur d'usure $U_i$ correspond à l'usure pour une batterie 2 ayant une température interne $T$ de 15°C et un état de charge $SOC$ de 90%, lorsque le véhicule est inactif.

Une fois ce calcul effectué, le calculateur électronique 3 fournit un résultat exprimé en durée d'utilisation ou temps passé, en heures ou en jours selon la durée $A$ durant laquelle le véhicule 1 est resté inactif. Ce résultat en temps passé permet facilement de représenter l'usure qu'a pris la batterie 2 sur la durée $A$.

Au cours de l'étape 22 suivante, un compteur ajoute ce résultat à l'indicateur d'usure total de la batterie 2. Le résultat de cette somme devient le nouvel indicateur d'usure total de la batterie 2.

La suite du procédé, illustré par l'étape 23, permet au véhicule 1 de bénéficier d'un suivi en continu de l'usure de la batterie 2 lorsque le véhicule 1 est actif. En effet, lorsque le véhicule 1 est actif, le calculateur électronique 3 récupère chaque minute la température interne $T$ de la batterie 2 afin de calculer son indicateur d'usure $U_a$, selon la relation :

$$U_a = A * K_T$$

Dans laquelle $K_T$ est le facteur d'usure selon la température interne $T$ de la batterie 2 déterminé d'après la loi Arrhenius définie par le tableau I.

Chaque minute, après le calcul de l'indicateur d'usure $U_a$, le compteur additionne cette donnée à l'indicateur d'usure total de la batterie 2 (étape 24), afin d'obtenir le nouvel indicateur d'usure total de la batterie 2.

En référence à la figure 2 (flèche L1), tant que le véhicule 1 est actif, les étapes 23 et 24 sont réitérées en boucle. Sinon, si le véhicule devient inactif, le procédé se poursuit par l'étape 25.

Lorsque le véhicule 1 redevient actif après une période d'inactivité, la boucle L2 permet de retourner à l'étape 21, dans laquelle le calculateur électronique recommence le calcul de l'indicateur d'usure $U_p$ correspondant à l'usure de la batterie 2 durant la phase d'inactivité du véhicule 1.

Si l'indicateur d'usure total s'approche de 8 ans, c'est-à-dire d'environ 70128 heures, le système de surveillance connecté du véhicule 1 envoie un signal d'alerte, illustré par l'étape E, au constructeur qui a accès aux données du véhicule 1 et peut contacter le propriétaire du véhicule, afin de procéder à un changement de la batterie 2.

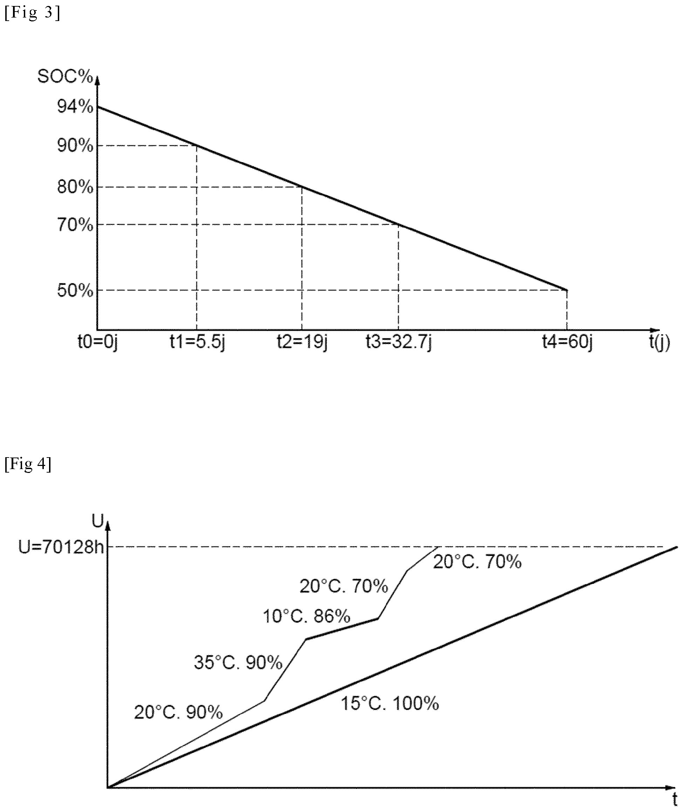

La figure 3 montre un exemple d'évolution de l'état de charge $SOC$ de la batterie 2 d'un véhicule 1 inactif pendant une durée de 60 jours. Dans l'exemple illustré, à l'instant t0, le véhicule devient inactif, et l'état de charge *SOC* de la batterie 2 est de 94%. A l'instant t4, à la fin des 60 jours, l'état de charge *SOC* de la batterie 2 est de 50%.

Lorsque le véhicule est réactivé après les 60 jours d'inactivité, le calculateur électronique 3 procède au calcul de l'étape 21 précédemment décrite.

L'indicateur d'usure $U_{SOC}$ correspond à l'usure de la batterie en fonction de l'état de charge *SOC.*

Puisque l'état de charge *SOC* de la batterie 2 diminue de 44% pendant la durée d'inactivité du véhicule 1, le calcul de $U_{SOC}$ est découpé en plusieurs périodes d'analyse, à savoir une première période d'analyse allant de t0 à t1, une deuxième période d'analyse allant de t1 à t2, une troisième période d'analyse allant de t2 à t3, et une quatrième période d'analyse allant de t3 à t4. Ces intervalles permettent de suivre les intervalles de 10% du tableau II de l'usure de la batterie 2 en fonction de l'état de charge.

Pour une variation de 44% de l'état de charge *SOC* de la batterie 2 en 60 jours, la perte de charge pour un jour *l* est de 0.733%/jour.

Les calculs de l'indicateur d'usure $U_{SOC}$ selon chaque période d'analyse s'effectuent ainsi :

- Première période d'analyse allant de t0 à t1 et allant de 94% à 90% en état de charge *SOC* de la batterie 2, sur une durée de 5,5 jours. D'après le tableau II, pour $SOC_b$ = 90%, $K_{SOC_b}$ = 1 :

$$U_{SOC_{t1}} = \frac{(SOC_a - SOC_b)}{l} * K_{SOC_b} = \frac{(94\% - 90\%)}{0.733} * 1 = 5,46 * 1 = 5,46\ jours$$

Sur cette période d'analyse de 5,5 jours, la batterie 2 s'est usée comme une batterie ayant un état de charge *SOC* constant de 90% s'userait en 5,46 jours.

- Deuxième période d'analyse allant de t1 à t2 et allant de 90% à 80% en état de charge *SOC* de la batterie 2, sur une durée de 13,5 jours.

D'après le tableau II, pour $SOC_b$ = 80%, $K_{SOC_b}$ = 1,1 :

$$U_{SOC_{t2}} = \frac{(SOC_a - SOC_b)}{l} * K_{SOC_b} = \frac{(90\% - 80\%)}{0.733} * 1,1 = 13,64 * 1,1 = 15\ jours$$

Sur cette période d'analyse de 13,5 jours, la batterie 2 s'est usée comme une batterie ayant un état de charge *SOC* constant de 90% s'userait en 15 jours.

- Troisième période d'analyse allant de t2 à t3 et allant de 80% à 70% en état de charge *SOC* de la batterie 2, sur une durée de 13,7 jours.

D'après le tableau II, pour $SOC_b$ = 70%, $K_{SOC_b}$ = 3 :

$$U_{SOC_{t3}} = \frac{(SOC_a - SOC_b)}{l} * K_{SOC_b} = \frac{(80\% - 70\%)}{0.733} * 3 = 13.64 * 3 = 40,93\ jours$$

Sur cette période d'analyse de 13,5 jours, la batterie 2 s'est usée comme une batterie ayant un état de charge *SOC* constant de 90% s'userait en 40,93 jours.

- Quatrième période d'analyse allant de t3 à t4 et allant de 70% à 50% en état de charge *SOC* de la batterie 2, sur une durée de 27,3 jours.

D'après le tableau II, pour $SOC_b$ = 50%, $K_{SOC_b}$ = 8 :

$$U_{SOC_{t4}} = \frac{(SOC_a - SOC_b)}{l} * K_{SOC_b} = \frac{(70\% - 50\%)}{0.733} * 8 = 27,29 * 8 = 218,28\ jours$$

Sur cette période d'analyse de 27,3 jours, la batterie 2 s'est usée comme une batterie ayant un état de charge *SOC* constant de 90% s'userait en 218,28 jours.

Après avoir calculé chacune de ces étapes, le calculateur électronique 3 calcule la somme des résultats pour délivrer l'indicateur total $U_{SOC}$ sur cette période d'inactivité du véhicule 1 avec :

$$U_{SOC} = U_{SOC_{t0-t1}} + U_{SOC_{t1-t2}} + U_{SOC_{t2-t3}} + U_{SOC_{t3-t4}} = 5,46 + 15 + 40,93 + 218,28$$
$$= 279,67 \; jours$$

Au cours des 60 jours d'inactivité du véhicule 1, la batterie 2 s'est usée comme une batterie ayant un état de charge *SOC* constant de 90% sur les 60 jours s'userait en 279,67 jours.

En cumulant l'indicateur d'usure lorsque le véhicule 1 est actif, liée à la température, et l'indicateur d'usure lorsque le véhicule 1 est inactif, liée à la température et l'état de charge, le calculateur électronique 3 obtient un indicateur d'usure total U en temps passé.

La figure 4 illustre graphiquement un exemple de réalisation de l'invention, montrant l'évolution de l'usure U de la batterie 2 selon ses conditions de température interne et d'état de charge, en fonction du temps d'usage t.

**Revendications**

1. Procédé de détermination d'un indicateur d'usure d'une batterie (2) au plomb pour véhicule automobile (1), **caractérisé en ce que** l'on calcule en continu un indicateur d'usure de la batterie (2) selon un mode d'usage du véhicule (1) et en fonction de paramètres de fonctionnement de la batterie (2), ledit procédé comprenant les étapes suivantes :

   - Lorsque le véhicule (1) est actif, calcul d'un premier indicateur d'usure ($U_a$) de la batterie (2) à l'aide de paramètres de fonctionnement comprenant un temps d'analyse (*A*) et la température interne (*T*) de la batterie (2),
   - Lorsque le véhicule (1) est inactif, calcul d'un second indicateur d'usure ($U_p$) de la batterie (2) à l'aide de paramètres de fonctionnement comprenant un temps d'analyse (*A*), la température interne (*T*) de la batterie (2), ainsi que l'état de charge (*SOC*) de la batterie (2),

   lesdits premier et second indicateurs d'usure ($U_a$, $U_p$) étant additionnés à un indicateur d'usure total de la batterie (2), stocké dans le véhicule automobile (1), le résultat de cette somme devenant le nouvel indicateur d'usure total de la batterie (2).

2. Procédé selon la revendication 1, dans lequel le premier indicateur d'usure ($U_a$) de la batterie (2) au plomb lorsque le véhicule automobile (1) est actif, est calculé selon la relation :

$$U_a = A * K_T$$

   dans laquelle :
   $K_T$ est un facteur d'usure déterminé selon la loi Arrhenius, représentant une usure proportionnelle au temps d'analyse *A* et en fonction de la température interne *T* de la batterie (2).

3. Procédé selon la revendication 1, dans lequel le second indicateur d'usure ($U_p$) de la batterie (2) au plomb lorsque le véhicule automobile (1) est inactif, est calculé selon la relation :

$$U_p = U_T + U_{SOC} - U_i$$

   dans laquelle :

   $U_T$ est l'usure de la batterie (2) en fonction de la température *T* et correspond à :
   $U_T = A * K_T$ ; si le temps d'analyse *A* est inférieur ou égal à 24 heures, ou :
   $U_T = (24 * K_T) + ((A - 24) * K_{Ta})$ ; si le temps d'analyse *A* est supérieur à 24 heures,
   Avec $K_T$ le facteur d'usure déterminé selon la loi Arrhenius et :

$$T = \frac{(T_s + T_a)}{2}$$

dans laquelle :

$T_s$ est la température interne de la batterie (2) juste avant que le véhicule (1) ne devienne inactif, et $T_a$ la température interne de la batterie (2) lorsque le contact est mis, c'est-à-dire lorsque le véhicule (1) devient actif, $U_{SOC}$ est un indicateur d'usure de la batterie (2) en fonction de l'état de charge $SOC$ de la batterie (2), et $U_i$ est l'indicateur d'usure initial de la batterie (2) ;

4. Procédé selon la revendication 3, dans lequel l'indicateur d'usure ($U_{SOC}$) de la batterie (2) au plomb lorsque le véhicule (1) est inactif est déterminé selon la relation :

$$U_{SOC} = \frac{(SOC_a - SOC_b)}{l} * K_{SOC_b}$$

dans laquelle :

- $SOC_a$ est l'état de charge de la batterie (2) au début d'une période d'analyse,
- $SOC_b$ l'état de charge de la batterie (2) à la fin d'une période d'analyse, l'état de charge étant pondérée par un coefficient d'usure $K_{SOC_b}$ correspondant à l'état de charge $SOC_b$, et
- $l$ est la perte de charge pour un jour.

5. Procédé selon la revendication 3, dans lequel l'indicateur d'usure ($U_i$) de la batterie (2) au plomb correspond à l'usure d'une batterie (2) ayant une température interne ($T$) de 15°C et un état de charge ($SOC$) de 90%, lorsque le véhicule (1) est inactif.

6. Procédé selon l'une quelconque des revendications 1 à 5, dans lequel l'indicateur d'usure de la batterie (2) au plomb correspondant au mode d'usage du véhicule (1) est calculé périodiquement, et l'indicateur d'usure de la batterie (2) correspondant au mode d'usage du véhicule (1) inactif est calculé au moment où le véhicule devient actif.

7. Système de détermination d'un indicateur d'usure d'une batterie (2) au plomb pour véhicule automobile (1), **caractérisé en ce qu'**il comprend un calculateur électronique (3) configuré pour calculer en continu un indicateur d'usure de la batterie (2) selon un mode d'usage du véhicule (1) et en fonction de paramètres de fonctionnement de la batterie (2), ledit calcul de l'indicateur d'usure de la batterie (2) comprenant les étapes suivantes :

- Lorsque le véhicule (1) est actif, calcul d'un premier indicateur d'usure ($U_a$) de la batterie (2) à l'aide de paramètres de fonctionnement comprenant un temps d'analyse ($A$), et la température interne ($T$) de la batterie (2),
- Lorsque le véhicule (1) est inactif, calcul d'un second indicateur d'usure ($U_p$) de la batterie (2) à l'aide de paramètres de fonctionnement comprenant un temps d'analyse ($A$), la température interne ($T$) de la batterie (2), ainsi que l'état de charge ($SOC$) de la batterie (2),

lesdits premier et second indicateurs d'usure ($U_a$, $U_p$) calculés étant additionnés à un indicateur d'usure total de la batterie (2), stocké dans le calculateur électronique (3), le résultat de cette somme devenant le nouvel indicateur d'usure total de la batterie (2).

8. Véhicule automobile (1) comprenant un système de détermination d'un indicateur d'usure, selon la revendication 7.

[Fig 1]

[Fig 2]

[Fig 3]

[Fig 4]

Europäisches
Patentamt

European
Patent Office

Office européen
des brevets

# RAPPORT DE RECHERCHE EUROPEENNE

**Numéro de la demande**

EP 24 17 2895

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | FR 2 976 367 A1 (PEUGEOT CITROEN AUTOMOBILES SA [FR]) 14 décembre 2012 (2012-12-14) | 1,2,6-8 | INV. G01R31/379 G01R31/392 |
| A | * pages 11-16; revendications 1-10; figures 1-3 * | 3-5 | |
| X | US 2012/130655 A1 (MITSUDA KENRO [JP] ET AL) 24 mai 2012 (2012-05-24) | 1,2,6-8 | |
| A | * alinéas [0027] - [0096]; revendications 1-17; figures 1-9 * | 3-5 | |
| X | US 2021/080506 A1 (WAMPLER CHARLES W [US] ET AL) 18 mars 2021 (2021-03-18) | 1,2,6-8 | |
| A | * alinéas [0026] - [0129]; revendications 1-20; figures 1-3 * | 3-5 | |
| X | GB 2 586 655 A (SIEMENS PLC [GB]; THE UNIV OF NEWCASTLE UPON TYNE [GB]) 3 mars 2021 (2021-03-03) | 1,2,6-8 | |
| A | * pages 5-13; revendications 1-15; figures 1-8 * | 3-5 | DOMAINES TECHNIQUES RECHERCHES (IPC) |
| X | EP 3 974 853 A1 (COMMISSARIAT ENERGIE ATOMIQUE [FR]; BHG [FR]) 30 mars 2022 (2022-03-30) | 1,2,6-8 | G01R H01M H02J |
| A | * alinéas [0025] - [0064]; revendications 1-3; figures 1-2 * | 3-5 | |
| X | GB 2 586 654 A (SIEMENS PLC [GB]; THE UNIV OF NEWCASTLE UPON TYNE [GB]) 3 mars 2021 (2021-03-03) | 1,2,6-8 | |
| A | * pages 6,7; revendications 1-15; figures 1-14 * | 3-5 | |

Le présent rapport a été établi pour toutes les revendications

| Lieu de la recherche | Date d'achèvement de la recherche | Examinateur |
|---|---|---|
| Munich | 2 septembre 2024 | Bilzer, Claus |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 24 17 2895

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-09-2024

| Document brevet cité au rapport de recherche | Date de publication | Membre(s) de la famille de brevet(s) | Date de publication |
|---|---|---|---|
| FR 2976367 A1 | 14-12-2012 | AUCUN | |
| US 2012130655 A1 | 24-05-2012 | JP 5599375 B2 | 01-10-2014 |
| | | JP 2012127938 A | 05-07-2012 |
| | | US 2012130655 A1 | 24-05-2012 |
| US 2021080506 A1 | 18-03-2021 | CN 112505562 A | 16-03-2021 |
| | | US 2021080506 A1 | 18-03-2021 |
| GB 2586655 A | 03-03-2021 | GB 2586655 A | 03-03-2021 |
| | | WO 2021044134 A1 | 11-03-2021 |
| EP 3974853 A1 | 30-03-2022 | EP 3974853 A1 | 30-03-2022 |
| | | ES 2956947 T3 | 05-01-2024 |
| | | FR 3114404 A1 | 25-03-2022 |
| | | PL 3974853 T3 | 04-12-2023 |
| | | PT 3974853 T | 11-09-2023 |
| GB 2586654 A | 03-03-2021 | GB 2586654 A | 03-03-2021 |
| | | WO 2021044132 A1 | 11-03-2021 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6836122 B